# EUROPÄISCHE PATENTSCHRIFT

(11) **EP 2 893 618 B1**
(45) Veröffentlichungstag und Bekanntmachung des Hinweises auf die Patenterteilung: **06.07.2016**
(21) Anmeldenummer: 13745121.7
(22) Anmeldetag: 06.08.2013
(51) Int. Cl.: H02K 11/00

(54) **ÜBERSPANNUNGSSCHUTZVORRICHTUNG FÜR EINE ELEKTRISCHE MASCHINE**
SURGE ARRESTER FOR AN ELECTRIC MACHINE
DISPOSITIF DE PROTECTION D'UNE MACHINE ÉLECTRIQUE CONTRE LES SURTENSIONS

(30) Priorität: 03.09.2012 DE 102012215557
(43) Veröffentlichungstag der Anmeldung: 15.07.2015
(73) Patentinhaber: Robert Bosch GmbH, 70442 Stuttgart (DE)
(72) Erfinder: STIEFEL, Tobias, 76534 Baden-Baden (DE)
(86) Internationale Anmeldenummer: PCT/EP2013/066442
(87) Internationale Veröffentlichungsnummer: WO 2014/032914

(56) Entgegenhaltungen:
- EP-A1- 1 120 888
- DE-A1-102007 029 906
- JP-A- S6 110 945

## Beschreibung

Die Erfindung betrifft eine Überspannungsschutzvorrichtung für eine elektrische Maschine.

### Stand der Technik

Es ist bekannt, dass Kondensatoren oder Lösch-Dioden als Überspannungsabieiter an Pins von elektronischen Bauelementen zum Zwecke eines Schutzes vor elektrostatischer Entladung (ESD, engl. electro static discharge) eingesetzt werden, um einen ESD-Puls gegen Massepotential abzuleiten.

Ferner sind an Gehäusen elektronischer Bauelemente Ableitstrecken bekannt, die mittels Kondensatoren auf Massepotential bzw. von den Gehäusen direkt auf Massepotential realisiert sind.

DE 10 2009 015 962 A1 offenbart einen elektrostatischen Entladungsschutz, der in Form eines diskreten Arrays mit einem spannungsvariablen Material oder einer Vorrichtung mit einem spannungsvariablem Material bereitgestellt wird. Das Array wird mit einer gemeinsamen Elektrode zum Verbinden mit Masse und einer oder mehreren Elektroden hergestellt, die zum Verbinden mit einer elektrischen Komponente konfiguriert sind. Die elektrische Komponente ist ein Verbinder, der an einer elektrischen Schaltung angebracht ist, die Vorrichtungen enthält, die einer Schädigung durch ESD-Ereignisse ausgesetzt sind.

### Offenbarung der Erfindung

Es ist die Aufgabe der vorliegenden Erfindung, für eine elektrische Maschine eine verbesserte Schutzvorrichtung vor elektrostatischer Entladung bereit zu stellen.

Die Aufgabe wird gelöst mit einer Überspannungsschutzvorrichtung für eine elektrische Maschine, aufweisend:
ein Attrappen-Bauelement, welches im Vergleich mit Bauelementen auf einer Leiterplatte der elektrischen Maschine den geringsten Abstand zu einem Entladungselement der elektrischen Maschine aufweist, wobei das Attrappen-Bauelemente an wenigstens einem Anschluss mit Massepotential verbunden ist. Auf diese Weise wird vorteilhaft eine Vorzugs-Ableitstrecke gebildet, auf der mit hoher Wahrscheinlichkeit ein Überschlag einer elektrostatischen Entladung vom Entladungselement auf das nicht-funktionale Attrappen-Bauelement erfolgt. Vorteilhaft werden dadurch ein zu schützendes elektronisches Bauelement, und damit die gesamte elektrische Maschine vor schädlichen Auswirkungen der ESD-Entladung bewahrt.

Eine bevorzugte Ausführungsform der Überspannungsschutzvorrichtung ist dadurch gekennzeichnet, dass das Attrappen-Bauelement auf der Leiterplatte der elektrischen Maschine angeordnet ist. Dadurch kann vorteilhaft besonders einfach ein Schutz für ein ebenfalls auf der Leiterplatte angeordnetes zu schützendes elektronisches Bauelement bereitgestellt werden. Ferner ist dadurch das Attrappen-Bauelemente innerhalb der elektrischen Maschine besonders einfach anzuordnen.

Eine bevorzugte Ausführungsform der Überspannungsschutzvorrichtung ist dadurch gekennzeichnet, dass das Attrappen-Bauelemente auf allen elektrischen Anschlüssen mit Massepotential verbunden ist. Dadurch entsteht ein besonders guter Schutz- bzw. Erdungseffekt für einen ESD-Überschlag.

Eine bevorzugte Ausführungsform der erfindungsgemäßen Überspannungsschutzvorrichtung sieht vor, dass das Attrappen-Bauelement alle anderen Bauelemente auf der Leiterplatte überragt. Dadurch wird ein Minimalabstand zum Entladungselement bereitgestellt, wodurch auf einfache Weise lediglich aufgrund von geometrischen Abmessungen des Attrappen-Bauelements ein voraussichtliches Überschlagsverhalten ausgestaltet werden kann.

Eine bevorzugte Ausführungsform der Überspannungsschutzvorrichtung zeichnet sich dadurch aus, dass das Attrappen-Bauelement in einer Stückliste der Leiterplatte vorhanden ist. Dadurch entstehen vorteilhaft geringe Zusatzkosten für die Realisierung der Überspannungsschutzvorrichtung. In einem Fertigungsprozess braucht man kein zusätzliches Bauteil und es kann dabei vorteilhaft ein Standardprozess verwendet werden.

Eine bevorzugte Ausführungsform der erfindungsgemäßen Überspannungsschutzvorrichtung sieht vor, dass die Masseleitung auf der Leiterplatte derart angeordnet ist, dass sie einen möglichst kurzen Weg auf der Leiterplatte ausbildet. Dadurch kann die Entladungsenergie vorteilhaft auf kurzem Wege abgeführt werden, so dass sie nicht andere Elemente auf der Leiterplatte gefährden kann. Vorteilhaft können auf diese Art und Weise elektrische Spannungsspitzen von zu schützenden Bauelementen der Leiterplatte im Wesentlichen ferngehalten werden.

Eine bevorzugte Ausführungsform der erfindungsgemäßen Überspannungsschutzvorrichtung zeichnet sich dadurch aus, dass das Attrappen-Bauelement ein Keramikkondensator ist. Derartige Bauelemente sind in der Regel in geometrischer Hinsicht die höchsten Bauelemente auf einer gedruckten Leiterplatine, sodass man dadurch in einem Fertigungsprozess eine kostengünstige Möglichkeit zur Realisierung des Überspannungsschutzes hat.

Eine vorteilhafte Weiterbildung der Entladungsschutzvorrichtung sieht vor, dass das Attrappen-Bauelement ein elektrischer Widerstand ist. Auch mit diesem Bauelement steht ein Typ von Bauelement zur Verfügung, der bereits in einem Fertigungsprozess vorhanden ist und dadurch eine kostengünstige und effiziente Ausgestaltung der Überspannungsschutzvorrichtung ermöglicht.

Eine bevorzugte Ausführungsform der erfindungsgemäßen Überspannungsschutzvorrichtung sieht vor, dass das Attrappen-Bauelement ein Kontaktierungs-Pin ist. Dadurch wird eine besonders einfache und kostengünstige Möglichkeit zur Realisierung einer Ausführungsform der Erfindung bereitgestellt.

Durch die erfindungsgemäße Vorrichtung kann vorteilhaft eine Sicherheitsstufe für die elektrische Maschine dahingehend erhöht werden, dass im Betrieb auftretende ESD-Entladungsvorgänge zu schützende Elemente der elektrischen Maschine nicht schädigen können. Dadurch kann eine fehlerfreie Betriebsdauer der elektrischen Maschine vorteilhaft wesentlich verlängert sein. Vorteilhaft ist ein zusätzlicher Aufwand zur Bereitstellung der erfindungsgemäßen Überspannungsschutzvorrichtung sehr gering.

Die Erfindung wird im Folgenden mit weiteren Merkmalen und Vorteilen anhand von zwei Figuren detailliert beschrieben. Dabei bilden alle beschriebenen oder dargestellten Merkmale für sich oder in beliebiger Kombination den Gegenstand der Erfindung, unabhängig von ihrer Zusammenfassung in den Patentansprüchen oder deren Rückbeziehung, sowie unabhängig von ihrer Formulierung bzw. Darstellung in der Beschreibung bzw. in den Figuren. Die Figuren sind vor allem dazu gedacht, die erfindungswesentlichen Prinzipien zu verdeutlichen und sind nicht notwendigerweise detail- bzw. maßstabsgetreu.

In den Figuren zeigt:
- Fig. 1: eine prinzipielle Vorderansicht auf eine Ausführungsform der erfindungsgemäßen Überspannungsschutzvorrichtung; und
- Fig. 2: eine prinzipielle Draufsicht auf eine Ausführungsform der erfindungsgemäßen Überspannungsschutzvorrichtung.

### Ausführungsformen der Erfindung

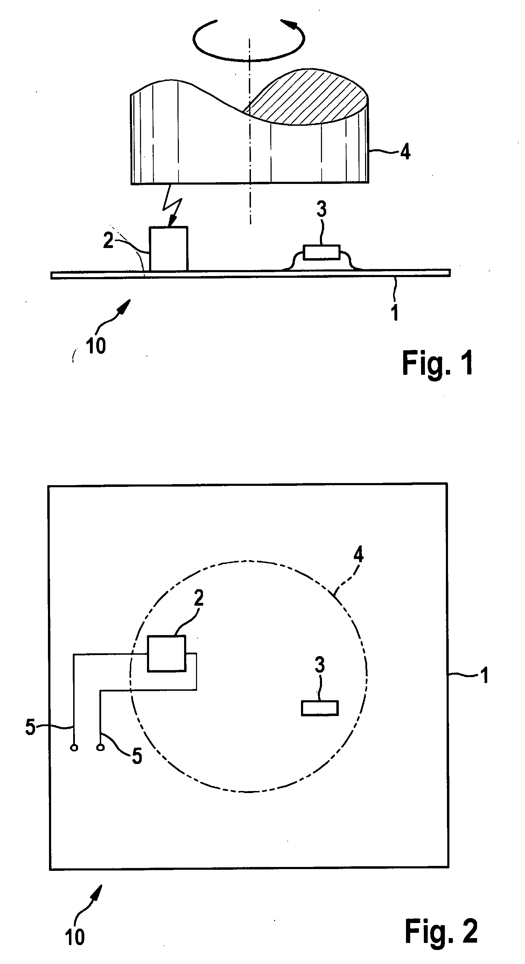

Fig. 1 zeigt in einer prinzipiellen Vorderansicht eine prinzipielle Darstellung einer Ausführungsform der erfindungsgemäßen Überspannungsschutzvorrichtung für eine elektrische Maschine. Ein elektrostatischer Entladungsüberschlag kann von einer um eine Drehachse rotierbaren Welle 4 der elektrischen Maschine auf elektrische bzw. elektronische Bauelemente, die unterhalb der Welle 4 auf einer Leiterplatte 1 angeordnet sind, erfolgen. Dies ist beispielsweise dadurch begründet, dass während des Betriebs der elektrischen Maschine ein dünner Ölfilm auf der Welle 4 entsteht, wodurch eine niederohmige elektrisch leitende Verbindung mit einem Massepotential (z.B. Gehäusemasse) verhindert wird. Auf diese Weise entsteht mit der Zeit eine Ladungsüberhöhung, die sich in einem elektrostatischen Entladungsvorgang (ESD-Funke) auf ein unterhalb der Welle 4 angeordnetes Sensorelement 3 entlädt, welches dadurch geschädigt bzw. zerstört werden kann. Mit dem Sensorelement 3 werden in einem Normalbetrieb der elektrischen Maschine Winkelstellungen und/oder Drehzahlen der Welle 4 ermittelt, die einen Wischerarm eines Kraftfahrzeugs antreibt. Zu diesem Zweck kann beispielsweise ein Magnet (nicht dargestellt) auf die Welle 4 aufgepresst sein.

Es ist nunmehr erfindungsgemäß vorgesehen, in der Nähe des Sensorelements 3 ein Attrappen-Bauelement 2 auf der Leiterplatte 1 vorzusehen, welches derart ausgebildet und auf der Leiterplatte 1 angeordnet ist, dass es, verglichen mit anderen Bauelementen auf der Leiterplatte 1, einen minimalen Abstand zur Welle 4 aufweist. Auf diese Art und Weise wird ein elektrostatischer Überschlag mit hoher Wahrscheinlichkeit auf das Attrappen-Bauelement 2 erfolgen, wodurch das zu schützende Sensorelement 3 nicht geschädigt bzw. zerstört wird. Vorgesehen ist erfindungsgemäß also, dass das Attrappen-Bauelement 2 das bzw. die zu schützenden Bauelemente überragt, wobei ein Schutzeffekt umso höher ist, je mehr das Attrappen-Bauelement 2 das zu schützende Element überragt.

Als ein Beispiel für das Attrappen-Bauelement 2 kommen ein Keramikkondensator, ein Widerstand, ein Kontaktierungs-Pin usw. in Betracht. Vorteilhaft hängt eine Schutzwirkung ausschließlich von geometrischen Außenabmessungen des Attrappen-Bauelements 2 ab, wobei das Attrappen- bzw. Dummy-Bauelement 2 in einen funktionalen Betrieb der elektrischen Maschine nicht eingebunden ist. Vorteilhaft ist das Attrappen-Bauelement 2 also ein kostengünstiges Bauteil, welches üblicherweise bereits in einer Bestückungsliste der Leiterplatte 1 der elektrischen Maschine vorhanden ist und dadurch keine Zusatzkosten erzeugt.

Fig. 2 zeigt eine prinzipielle Draufsicht auf eine Ausführungsform der erfindungsgemäßen Überspannungsschutzvorrichtung 10. Es ist erkennbar, dass das Attrappen-Bauelement 2 mittels elektrischer Leitungen 5 der Leiterplatte 1 an beiden Seiten derart verbunden ist, dass die Leitungen 5 auf kurzem Weg vom Attrappen-Bauelement 2 wegführen bzw. mit einer möglichst kurzen Leitungsführung auf der Leiterplatte 1 realisiert sind. Vorzugsweise werden die Leitungen 5 zu einem Massesternpunkt geführt, der die elektrostatische Entladungsenergie sammelt und über Durchkontaktierungen auf einen Stecker (nicht dargestellt), und damit von der Leiterplatte 1 abführt. Schädliche elektrische Spannungsspitzen können auf diese Art und Weise vorteilhaft von funktionalen Bauelementen der Leiterplatte 1 im Wesentlichen ferngehalten werden. Die Leitungen 5 sollten vorzugsweise möglichst niederohmig ausgebildet sein.

Zusammenfassend wird mit der Erfindung eine einfache und effiziente Möglichkeit bereitgestellt, um elektronische Bauelemente bzw. ganze Baugruppen auf einer Leiterplatte einer elektrischen Maschine vor elektrostatischen Entladungen zu schützen. Vorteilhaft wird dies mittels geometrischer Abmessungen eines Attrappen-Bauelements erreicht, welches derart ausgebildet ist, dass es einen Minimalabstand zwischen Endpunkten einer Entladungsstrecke der elektrischen Maschine bereitstellt. Ein ESD-Funke, der beispielsweise aufgrund von elektrostatischer Aufladung durch ein Wischen auf einer trockenen Scheibe entsteht, kann auf diese Weise innerhalb eines Wischermotors auf einer minimal kurzen und niederohmigen Strecke unschädlich geführt werden.

Es ist für den Fachmann erkennbar, dass das erfindungsgemäße Prinzip nicht auf eine elektrische Maschine mit einer rotierenden Welle beschränkt ist, sondern in analoger Weise auf jegliche Vorrichtungen anwendbar ist, bei denen elektrostatische Entladungen auftreten können und/oder bei denen eine definierte ESD-Überschlagsstrecke generiert werden soll. Beispielsweise ist es nicht unbedingt erforderlich, das Attrappen-Bauelement direkt auf der Leiterplatte anzuordnen.

Der Fachmann wird also die beschriebenen Merkmale miteinander kombinieren oder abändern, ohne vom Kern der Erfindung abzuweichen.

## Patentansprüche

1. Überspannungsschutzvorrichtung für eine elektrische Maschine, aufweisend: ein Attrappen-Bauelement (2), welches im Vergleich mit Bauelementen einschließlich einem zu schützenden Sensorelement (3), auf einer Leiterplatte (1) der elektrischen Maschine den geringsten Abstand zu einer drehbaren Welle (4) der elektrischen Maschine aufweist, wobei das Attrappen-Bauelement (2) auf allen elektrischen Anschlüssen mit Massepotential verbunden ist.

2. Überspannungsschutzvorrichtung nach Anspruch 1, **dadurch gekennzeichnet, dass** das Attrappen-Bauelemente (2) auf der Leiterplatte (1) der elektrischen Maschine angeordnet ist.

3. Überspannungsschutzvorrichtung nach Anspruch 1 oder 2, **dadurch gekennzeichnet, dass** das Attrappen-Bauelement (2) alle anderen Bauelemente auf der Leiterplatte (1) überragt.

4. Überspannungsschutzvorrichtung nach einem der Ansprüche 1 bis 3, **dadurch gekennzeichnet, dass** das Attrappen-Bauelement (2) in einer Stückliste der Leiterplatte (1) vorhanden ist.

5. Überspannungsschutzvorrichtung nach einem der vorhergehenden Ansprüche, **dadurch gekennzeichnet, dass** die Masseleitung auf der Leiterplatte (1) derart angeordnet ist, dass sie einen möglichst kurzen Weg auf der Leiterplatte (1) ausbildet.

6. Überspannungsschutzvorrichtung nach einem der vorhergehenden Ansprüche, **dadurch gekennzeichnet, dass** das Attrappen-Bauelement (2) ein Keramikkondensator ist.

7. Überspannungsschutzvorrichtung nach einem der vorhergehenden Ansprüche, **dadurch gekennzeichnet, dass** das Attrappen-Bauelement (2) ein elektrischer Widerstand ist.

8. Überspannungsschutzvorrichtung nach einem der vorhergehenden Ansprüche, **dadurch gekennzeichnet, dass** das Attrappen-Bauelement (2) ein Kontaktierungs-Pin ist.

9. Elektrische Maschine mit einer Überspannungsschutzvorrichtung nach einem der Ansprüche 1 bis8.

## Claims

1. Overvoltage protection apparatus for an electrical machine, having: a dummy component (2) which, in comparison with components, including a sensor element (3) which is to be protected, on a printed circuit board (1) of the electrical machine is at the shortest distance from a rotatable shaft (4) of the electrical machine, wherein the dummy component (2) is connected to earth potential at all electrical connections.

2. Overvoltage protection apparatus according to Claim 1, **characterized in that** the dummy component (2) is arranged on the printed circuit board (1) of the electrical machine.

3. Overvoltage protection apparatus according to Claim 1 or 2, **characterized in that** the dummy component (2) projects beyond all other components on the printed circuit board (1).

4. Overvoltage protection apparatus according to one of Claims 1 to 3, **characterized in that** the dummy component (2) is present in a parts list of the printed circuit board (1).

5. Overvoltage protection apparatus according to one of the preceding claims, **characterized in that** the earth line is arranged on the printed circuit board (1) in such a way that it forms as short a path as possible on the printed circuit board (1).

6. Overvoltage protection apparatus according to one of the preceding claims, **characterized in that** the dummy component (2) is a ceramic capacitor.

7. Overvoltage protection apparatus according to one of the preceding claims, **characterized in that** the dummy component (2) is an electrical resistor.

8. Overvoltage protection apparatus according to one of the preceding claims, **characterized in that** the dummy component (2) is a contact-making pin.

9. Electrical machine comprising an overvoltage protection apparatus according to one of Claims 1 to 8.

## Revendications

1. Dispositif de protection contre les surtensions destiné à une machine électrique, comprenant :
un composant factice (2) qui présente, par comparaison à des composants, y compris un élément capteur (3), présent sur une carte de circuit imprimé (1) de la machine électrique, la plus faible distance par rapport à un arbre tournant (4) de la machine électrique, dans lequel l'élément factice (2) est connecté, sur toutes les bornes électriques, au potentiel de la masse.

2. Dispositif de protection contre les surtensions selon la revendication 1, **caractérisé en ce que** le composant factice (2) est disposé sur la carte de circuit imprimé (1) de la machine électrique.

3. Dispositif de protection contre les surtensions selon la revendication 1 ou 2, **caractérisé en ce que** le composant factice (2) dépasse tous les autres composants présents sur la carte de circuit imprimé (1).

4. Dispositif de protection contre les surtensions selon l'une quelconque des revendications 1 à 3, **caractérisé en ce que** le composant factice (2) se trouve dans une nomenclature de la carte de circuit imprimé (1).

5. Dispositif de protection contre les surtensions selon l'une quelconque des revendications précédentes, **caractérisé en ce que** le conducteur de masse est disposé sur la carte de circuit imprimé (1) de manière à former un trajet le plus court possible sur la carte de circuit imprimé (1).

6. Dispositif de protection contre les surtensions selon l'une quelconque des revendications précédentes, **caractérisé en ce que** le composant factice (2) est un condensateur céramique.

7. Dispositif de protection contre les surtensions selon l'une quelconque des revendications précédentes, **caractérisé en ce que** le composant factice (2) est une résistance électrique.

8. Dispositif de protection contre les surtensions selon l'une quelconque des revendications précédentes, **caractérisé en ce que** le composant factice (2) est une broche de contact.

9. Machine électrique comportant un dispositif de protection contre les surtensions selon l'une quelconque des revendications 1 à 8.
